Europäisches Patentamt

European Patent Office

Office européen des brevets

(19)

(11) EP 1 498 515 A1

## (12) EUROPEAN PATENT APPLICATION
published in accordance with Art. 158(3) EPC

(43) Date of publication:
19.01.2005 Bulletin 2005/03

(21) Application number: 03715887.0

(22) Date of filing: 26.03.2003

(51) Int Cl.7: **C30B 15/14**

(86) International application number:
PCT/RU2003/000116

(87) International publication number:
WO 2003/083188 (09.10.2003 Gazette 2003/41)

(84) Designated Contracting States:
AT BE BG CH CY CZ DE DK EE ES FI FR GB GR
HU IE IT LI LU MC NL PT RO SE SI SK TR
Designated Extension States:
AL LT LV MK

(30) Priority: 02.04.2002 RU 2002108066

(71) Applicant: Kostin, Vladimir Vladimirovich
Moscow, 119121 (RU)

(72) Inventor: Kostin, Vladimir Vladimirovich
Moscow, 119121 (RU)

(74) Representative: Kietzmann, Manfred
Kietzmann & Vosseberg,
Patentanwalt-Rechtsanwalt-Partnerschaft,
Friedrichstrasse 95
10117 Berlin (DE)

## (54) DEVICE FOR PULLING MONOCRYSTALS

(57) The device comprises a crucible with a support, a heater and at least one heat-insulating screen, wherein, according to the invention, the heater is made of a starting flexible carbon-bearing material in the form of a cylinder whose ends are fixed between coaxially arranged rigid rings of carbon material that are connected to a power supply. And, the heater is made so that the wall thereof has its thickness determined from the relationship:

$$\delta \cdot \rho - c = 500 \text{ to } 8500 \text{ J/m}^2.$$

K, where:

$\delta$ - heater wall thickness, m; $\rho$ - density of the material the heater is made of, kg/m$^3$; and c - specific heat of the material the heater is made of (at working temperature), J/kg.K.

Fig. 5

## Description

### (i) Field of the Invention

The supposed invention relates to the field of metallurgy of semiconductors and can be used in growing single crystals of silicon, germanium and compounds of $A^{III}B^{V}$ group by the Czochralski method.

### (ii) State of Prior Art

Devices for growing single crystals are known in prior art to comprise a melt crucible mounted in a support and having a heater with current leads and a heat-insulation system arranged around it, wherein the support, the heater and the heat-insulation system are made of carbon materials [RF Patent No. 2081948, C30B 15/14, publ. 20.06.97; and RF Patent No. 2097451, C30B 15/14, publ. 27.11.97].

In pulling single crystals with the use of these devices, a heater having vertical slots is used. Such heater has a great mass, which increases heat losses and leads to substantial sluggishness with respect to heating and cooling, and this in turn affects the process control. The slots and uneven flow of current through various sections of the heater lead to disturbances in the symmetry of the heat field set up by the heater and to the deterioration, for this reason, of quality of single crystals thus produced. Immediate interaction of SiO vapors from the atmosphere of the growth chamber with heated carbon-bearing parts of the heating assembly leads to contamination of the growing crystal with carbon, which also affects its quality.

The closest to the claimed device is represented by a device for pulling single crystals, comprising a crucible with a support, a heater and a screen having a base of pressed graphite, the upper part of which is coated with a layer of pyrolytic carbon [Japanese Application No. 10-291896, C30B 29/06, publ. 04.11.98]. Such screen ensures stability of maintaining the temperature inside the crucible (impedes a pressure drop). However, a conventional heater with slots is also used here, which has the above-mentioned disadvantages.

### (iii) Disclosure of the Invention

The present invention is aimed at solving the technical problem consisting in a considerable reduction of the heater mass in order to reduce substantially the electric power consumption. Besides, a decrease in sluggishness of the heater is ensured thereby, and this facilitates the process control. Due to improving the symmetry of the heat field set up by the heater, the single crystals thus pulled become structurally more perfect. Also, the single crystals, when grown, have lower carbon content (at the level of the best analogs). In some embodiments of the device, expendable quartz crucibles can be abandoned, so that the manufacturing cost of finished products is thereby reduced. Besides, there is the possibility here to pull single crystals having lower oxygen content (similar to the crystals grown by the method of crucibleless zone melting), this allows using in future the method of neutron doping to produce ingots with a small spread of resistivity over both the end face and the volume. In this case, as compared with the crucibleless zone melting, the crystals can be of a larger diameter, and the finished products become much cheaper.

The design of the *device for pulling single crystals,* ensuring that the above-mentioned technical problem is accomplished in all instances, which are covered by the scope of legal protection as requested, can be characterized by the following combination of features.

*A device for pulling single crystals* comprises a crucible with a support, a heater and at least one heat-insulating screen. Also, *according to the invention,* the heater is made of a starting flexible carbon-bearing material in the form of a cylinder whose ends are fixed between coaxially arranged rigid rings of carbon material that are connected to a power supply. And, the heater is made so that the wall thereof has its thickness determined from the relationship:

$$\delta \cdot \rho \cdot c = 500 \text{ to } 8500 \text{ J/m}^{2}.$$

K, where:

$\delta$- heater wall thickness, m;
$\rho$ - density of the material the heater is made of, kg/$m^3$; and
c - specific heat of the material the heater is made of (at working temperature), J/kg.K.

The rings of carbon material can be connected to the power supply through heat-insulating screens.

A layer of silicon nitride can be provided on the heater surface on the inner and/or outer side thereof.

Besides, the crucible or the support can be made of silicon nitride.

The crucible and the support can be made of silicon nitride so as to be integral with one another.

The carbon-bearing material of the heater can be further sealed with pyrolytic carbon and/or silicon carbide.

The device can further comprise a heat-insulator of fabric and/or felt made of silica or quartz fibers.

The substance of the proposed technical solution consists in that the heater made of a flexible carbon-bearing material comprises a continuous (without slots) thin-walled cylinder, and the rings made of carbon material fix rigidly its shape and prevent this material from wrinkling. The mass of such heater is by orders of magnitude smaller than that of known analogs, whereby the electric power consumption decreases substantially, because a much smaller mass of the heater is subjected to heating up to the maximum temperatures, and there are no slots therein. The heater has a smaller sluggishness when it is heating up and cooling down. Owing to this, the process control improves. Besides, because there are no slots in the heater, the symmetry of the heat field set up by the heater is improved. Contamination of the growing crystal with carbon in the process of its growing is reduced considerably due to a layer of an inert material - silicon nitride isolating the inner and/or outer surface of the heater made of a carbon-bearing material from interaction with the atmosphere of the growth chamber where SiO vapors are contained. This layer also prevents the heater against the destruction and extends its service life. The protective layer of silicon nitride can be applied directly to the inner and/or outer surface of the heater. It is also possible to make a thin-walled cylinder of silicon nitride, which is inserted into the heater right up to its inner surface.

Sluggishness of the heater is characterized by the value of $\delta \cdot \rho \cdot c$, where: $\delta$ - heater wall thickness, m; $\rho$ - density of the material the heater is made of, $kg/m^3$; and c - specific heat of the material the heater is made of (at working temperature), J/kg.K. Optimal conditions are characterized by the relationship: $\delta \cdot \rho \cdot c = 500$ to $8500$ $J/m^2$.K, which has been obtained, based on the following considerations:

The heater, when electric current is flowing through it, releases heat at a rate that is equal to P = qF, where: P - heat output, W; F - area of the heater (or, more precisely, of that section thereof where the main quantity of power is released), $m^2$; and q - total density of the heat flow consisting of two parts: heat released as a result of that the electric current is flowing therethrough, and heat dissipated as a result of the heat exchange with the environment, $W/m^2$.

In a time $d\tau$, the heater accumulates the quantity of heat equal to dQ = P · $d\tau$, where $d\tau$ - time interval, s; and dQ - change in heat accumulated by the heater, J.

It is known that dQ = m · c · dT, where m - heater mass, kg; c - specific heat of the material of the heater, J/kg.K; and dT - range within which the heater temperature changes, K [Polytechnic Dictionary, edited by I.I. Artobolewski, M., Soviet Encyclopaedia, 1979, p.492].

Thus, it can be written as follows:

P · $d\tau$ = m · c · dT, or $d\tau$ = m · c · dT/F · q, but m = $\rho$ · V, where V - heater volume, $m^3$.

Since V = F · $\delta$, then $d\tau$ = $\delta \cdot \rho \cdot c \cdot dT/q$, or

$$\tau = \delta \cdot \rho \cdot c \cdot \int_{T_1}^{T_2} dT/q,$$

,

where $\tau$ - time in which the heater temperature changes from $T_1$ to $T_2$, with the total density of the heat flow being equal to q.

The value of $\delta \cdot \rho \cdot c$ is equivalent to the value of m · c/F.

Sluggishness of various heaters is compared on the basis of value $\tau$.

With the same temperature difference and the same heat flow densities, i.e. with the same values of the integral, the time is determined by the value of the product of $\delta \cdot \rho \cdot c$ (or m · c/F). The smaller the value of $\tau$, the less sluggish the heater is. The relationship $\delta \cdot \rho \cdot c$ (or m · c/F) relates the thermal physical properties of the material the heater is made of and its dimensions.

If the value of the product of the heater wall thickness by the specific heat and density of the material the heater is made of is less than 500 $J/m^2$.K, then the heater service life will be insufficient and will last for about five processes, but this is impermissible under industrial conditions.

If the value of the product of $\delta \cdot \rho \cdot c$ will be more than 8500 $J/m^2$.K, then the consumption of the flexible carbon-bearing material will unjustifiably increase, while the heater service life will not increase. In this case, sluggishness of the heater also will be too high. Besides, difficulties emerge here that are related to mating the unduly low electric resistance of the heater (load) with the power supply.

In the proposed device, the heater rings made of carbon material are connected with the power supply directly (through the current leads) and/or through the heat-insulating screens. In the latter case, the screen performs, simultaneously with the heat-insulating function, also the role of a current lead, hence allowing to deliver electric current more symmetrically to the heater and improve adaptability of the device to streamlined manufacture.

Coating of the inner and/or outer surface of the heater with silicon nitride as well as making both the support and the crucible of silicon nitride extend the service life of respective structural elements and also allow to eliminate contamination of the melt and the growing crystal with carbon atoms arriving from their surfaces because of the chemical interaction thereof with SiO vapors.

Using the embodiment of the device, wherein both the crucible and the crucible support are made of silicon nitride so as to be integral with one another, makes it possible to abandon the use of an expendable quartz crucible, this resulting in substantial savings, particularly when growing crystals from large (over 45 kg) charges in large diameter crucibles. In such device, owing to the absence of contact between the melt and quartz ($SiO_2$) and, hence, ingress of oxygen from the crucible to the melt, single crystals of silicon can be pulled which have lower content not only of carbon but also of oxygen. These ingots are similar to the crystals grown by the method of crucibleless zone melting. In future, they can be doped with neutrons in a nuclear reactor, so that much cheaper products are thus obtained than in case of using crystals after the crucibleless zone melting. Besides, crystals of a substantially larger diameter can be produced by the Czochralski method. In contrast to the single crystals of silicon grown by the conventional Czochralski method from a quartz crucible, here, because of the low content of oxygen, not too many radiation defects would occur after the neutron doping, and the finished products can be, therefore, used in electrical engineering and electronics. At the same time, all the advantages of the neutron doping method (uniform distribution of resistivity over the volume of the ingot) are retained here.

Further sealing of the heater by various materials extends its service life. In this case, the material of the heater becomes more rigid.

The heater service life becomes longer due to the fact that, when it is sealed with pyrolytic carbon, the thermochemical corrosion of the surface decreases.

Silicon carbide also makes the service life of the heater longer by decelerating the process of thermochemical corrosion. Besides, in case of applying the layer of silicon nitride, an intermediate layer is formed which improves adhesion of the layer of silicon nitride thus applied and reduces its destruction caused by the difference in the thermal expansion coefficients between silicon nitride and the carbon-bearing material of the heater.

Fabric and felt made of silica or quartz fibers, when they are placed on the heater and/or screens, ensure additional heat insulation. At the same time, they do not contaminate the growing crystal with carbon. The fabric is arranged in the manner such that the adjacent layers would not adhere directly to each other and a gap of 2 to 5 mm would exist between them, since this improves heat-insulating properties of screening at high temperatures. The fabric and/or felt can be also sealed, for instance, with silicon nitride, after they are placed appropriately.

As a starting flexible carbon-bearing material in making the heater, use can be made of various materials produced on the base of carbon: carbon fabric of Ural type, carbon fibers sealed with various substances (for instance, pyrolytic carbon, silicon carbide, etc.), thermoexpanded rolled graphite and the like.

It is known from the state of prior art in the related field of engineering to make use of carbon fabric and carbon fibers, including also those that are sealed with pyrolytic carbon, in screening systems of the plants for growing single crystals. In the proposed invention, the starting flexible carbon-bearing material is used not for screening but for making the heater of it, and namely, as a load resistor in the closed electric circuit, wherein power is released as a result of electric current flowing through it. In connection with this, the following problems related to operation of the heater are solved: reducing the mass and electric power consumption, reducing sluggishness of the heater and improving the heating/cooling control. As compared against the known technical solutions, the *device for pulling single crystals,* according to the present invention ensures attaining the **positive result** consisting in improving perfection of the pulled single crystals, with a decrease in the electric power consumption.

(iv) Description of the Drawings

The accompanying drawings show the following.

Figure 1 shows a longitudinal section of the device for pulling single crystals, wherein electric power is delivered to the heater through the upper and lower pairs of rings connected directly to the current leads. The heater is surrounded by a side and bottom heat-insulating screens.

Figure 2 presents a longitudinal section of the device, wherein electric power is delivered to the heater through the rings connected to the side and bottom screens performing simultaneously the function of current leads. The heater comprises a beaded thin-walled cylinder made of silicon nitride, which is disposed right against the inner walls of the heater.

Figure 3 presents an embodiment of the device, wherein the upper pair of rings is connected to the side screen playing the role of a current lead, and the lower pair of rings is connected directly to the other current lead. The bottom screen in the form of a bowl made of silicon nitride is placed on the bottom of the chamber. The crucible and the support are made of silicon nitride so that they are integral with one another.

Figure 4 presents an embodiment of the device shown in Figure 3, which is further provided with a system of upper screens of silicon nitride or of carbon material, for instance, graphite or a carbon-carbon composite.

Figure 5 presents an embodiment of the device shown in Figure 4, wherein the rings are made so that they are integral with the heater.

(v) Examples of the Embodiments of the Invention

Example 1

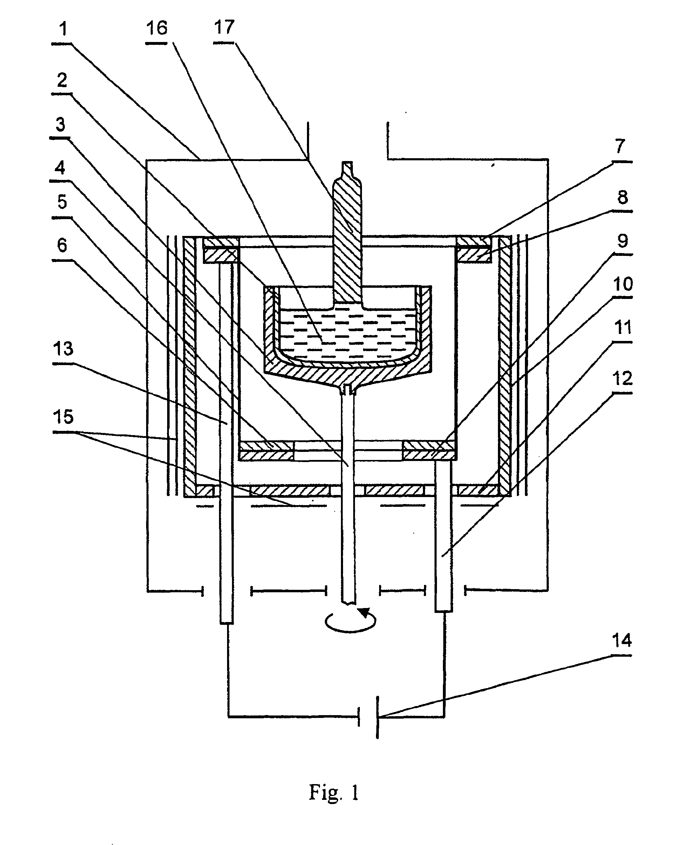

The process is carried out in a vacuum chamber 1. When growing a 150-mm diameter single crystal of silicon doped with boron from polycrystalline silicon containing $3 \times 10^{15}$ cm$^{-3}$ carbon and $2 \times 10^{16}$ cm$^{-3}$ oxygen, use is made of the device presented in Figure 1. In the subsequent examples, charge of the same material is used. A quartz crucible 2 having an outside diameter of 356 mm in a support 3 mounted to a rod 4 is used, with the 30-kg charge of polycrystalline silicon.

A heater 5 is made by way of knitting carbon fibers into a cylinder having a wall thickness of 0.6 mm (0.0006 m), with the use of a graphite mandrel. Then the ends of the cylinder are flanged to form a horizontal plane and clamped by contact rings 6, 7, 8, 9. A thin layer of silicon nitride is applied to the inner surface of the cylinder of the heater 5 (after the mandrel is removed). The operation of applying this layer is carried out by precipitation from a $SiCl_4$-$NH_3$-$H_2$ gaseous mixture, with the consumption of reagents being $1.17 \times 10^{-6}$, $10^{-6}$ and $1.3 \times 10^{-8}$ $m^3$/s, respectively, and at temperature of 1300 °C. The support 3 and the rod 4 as well as screens 10 and 11 are made of graphite and coated with a layer of silicon nitride.

The specific heat of the material of the heater is 2077 J/kg·K (at working temperature of 1600 °C, i.e. 1873 K), and the density of the material of the heater after knitting $\rho_{st}$ = 401.22 kg/$m^3$ ["Properties of the Structural Materials Based on Carbon". Reference book edited by B.A.Sosedov, M. Metallurgiya, 1975], that is, the product of $\delta \cdot \rho \cdot c$ is equal to 500 J/$m^2$·K.

After the quartz crucible 2 is mounted in the support 3 and filled with a silicon charge and a doping boron composition, the chamber 1 is sealed, vacuum of $10^{-3}$ mm Hg is provided therein, and electric power supply is switched on. Electric current from the power supply 14 passes through a current lead 13 and then via the rings 7 and 8 to the heater 5, whereupon it flows through the rings 6, 9 and a current lead 12 back to the power supply 14. The highest resistance in this series circuit is offered by the heater 5, wherein the main portion of heat is released. The heater 5 gets heated up to reach its working temperature of $\approx$ 1600 °C. Due to the heat transfer by radiation from the heater, the silicon charge 16 gets heated up and melts (the melt temperature is 1412 to 1500 °C). Then argon is supplied to the chamber, while pressure of 10 to 20 mm Hg is maintained in the chamber by simultaneously evacuating it continuously, using a vacuum pump (not shown in the figure). After this, a seed is lowered down into the melt and a single crystal 17 is grown.

After the process of growing is over, the single crystal is cooled down, removed from the chamber, whereupon samples are cut out of it and carbon content is determined which is $5 \times 10^{15}$ $cm^{-3}$.

The heater has low sluggishness. The time $\tau$ characterizing sluggishness of the heater is determined immediately after the charge is melt as the time from the instant when power decreases by 10 % to the instant when the heater temperature ceases to change. The measurements are taken by means of a pyrometer connected to a recorder. The time $\tau$ is 45 s as compared against 450 s for the prototype.

The heater remains serviceable for as long as 20 cycles of pulling.

Electric power consumption per 1 kg of finished products decreases here by 20 % and is 125 kW-hour/kg as compared against 155 kW-hour/kg for the prototype.

Example 2

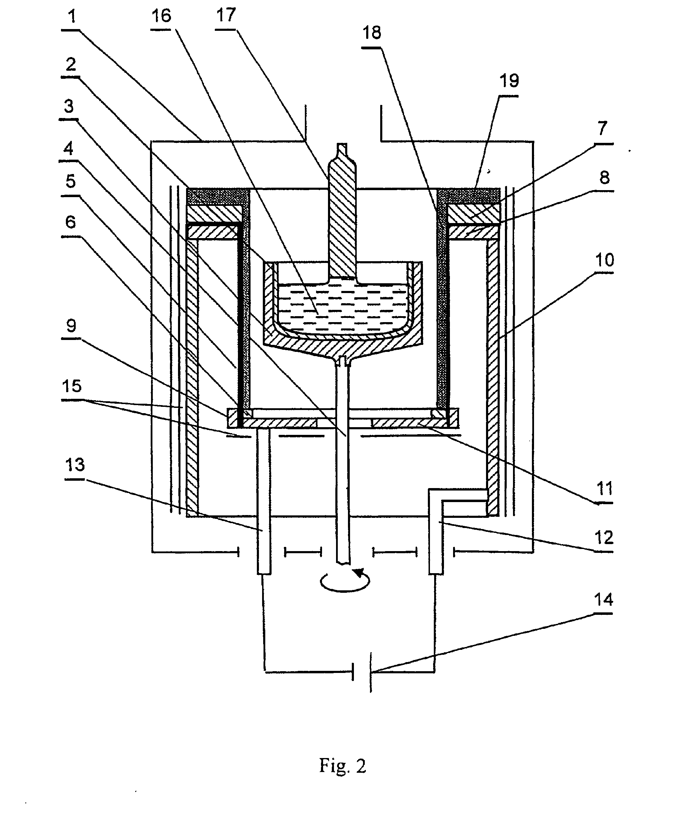

A single crystal is pulled with the use of the device presented in Figure 2. A 150-mm diameter single crystal of silicon doped with boron is thus produced from polycrystalline silicon containing $3 \times 10^{15}$ $cm^{-3}$ carbon. A quartz crucible having an outside diameter of 356 mm is used, with the charge being 30 kg. The screens 10 and 11 are made of graphite; they are electrically insulated from the chamber 1. The heater 5 is made as follows: carbon fabric of "Ural" type is wrapped in two layers around a mandrel of graphite. After this, the upper end face of the cylinder is cut into petals and clamped between rings 7 and 8 of carbon material (the length of the petals is equal to the width of the rings 7 and 8), and the lower end face is clamped between rings 6 and 9. Then a vertical seam is stitched with a carbon fiber. After the mandrel is removed, the heater and the heat-insulating screens/current leads are sealed with pyrolytic graphite using a known procedure for as long as 10 hours at temperature of 1050°C and pressure of 28 mm Hg in a flow of gas (methane) having a flow rate of 10 cm/s [Journal "Цветные металлы" (Non-Ferrous Metals), No. 9, 1980, pp.49-52]. Then the fabric of the heater is impregnated with an emulsion containing ethyl alcohol and fine silicon powder, whereupon annealing is carried out in vacuum first at 1300°C (3 hours) and then at 1500°C for as long as 5 hours. In doing so, the silicon powder and the carbon-bearing material of the heater interact with each other to be turned to silicon carbide. The heater wall thickness is 1.5 mm (0.0015 m).

Taking into account, that the specific heat of the material the heater is 2077 J/kg·K (at working temperature of 1600 °C, i.e. 1873 K), the starting density of the material of the heater $\rho_{st}$ = 400 kg/$m^3$, and the density after sealing $\rho$ = 800 kg/$m^3$, the product of $\delta \cdot \rho \cdot c$ is equal to 2492 J/$m^2$. The screens/current leads 10 and 11 of graphite are coated with a layer of silicon nitride. The support 3 and the rod 4 are made of graphite and, like the screens 10, 11, are coated with a layer of silicon nitride.

Then, a thin-walled cylinder 18 of silicon nitride (its wall thickness is 1.0 mm) having a bead 19 is placed inside the heater right against its inner surface. This cylinder protects the heater 5 and the upper contact rings 7 and 8 against chemical interaction with the atmosphere of the growth chamber containing SiO vapors. The cylinder of silicon nitride is made according to a known procedure [R.A.Andrievwsky, I.I.Spiwak, "Silicon Nitride and the Materials on Its Basis", M., Metallurgiya, 1984, pp.38-89], and then its wall thickness is made smaller in a lathe.

After the quartz crucible 2 is mounted in the support 3 and filled with a silicon charge and a doping boron composition, the chamber 1 is sealed, a vacuum is provided therein (residual pressure is $1 \cdot 10^{-3}$ mm Hg), and electric power supply is switched on. Electric current from the power supply 14 passes through the current lead 13 to the bottom screen 11 playing the role of a current supply and then via the rings 6 and 9 to the heater 5, the rings 7 and 8, the screen/current lead 10, and the current lead 12 whereupon it flows back to the power supply 14. The highest resistance in this series circuit is offered by the heater 5, wherein the main portion of heat is released. The heater 5 gets heated up to reach its working temperature of $\approx$ 1600 °C. Due to heat transfer by radiation from the heater, the silicon charge 16 gets heated up and melts (the melt temperature is 1412 to 1500 °C). Then argon is supplied to the chamber, while pressure of 10 to 20 mm Hg is maintained in the chamber by simultaneously evacuating it continuously, using a vacuum pump (not shown in the figure). After this, a seed is lowered down into the melt and a single crystal 17 is grown.

After the process of growing is over, the single crystal is cooled down, removed from the chamber, whereupon samples are cut out of it and carbon content is determined in the crystal thus produced which here is to be 4 x $10^{15}$ cm$^{-3}$.

The heater has low sluggishness. The time $\tau$ characterizing sluggishness of the heater is determined as mentioned herein above. The time $\tau$ is 60 s as compared against 450 s for the prototype. The heater remains serviceable for as long as 200 cycles of pulling.

Electric power consumption per 1 kg of finished products decreases here by 13 % and is 135 kW-hour/kg as compared against 155 kW-hour/kg for the prototype.

Example 3

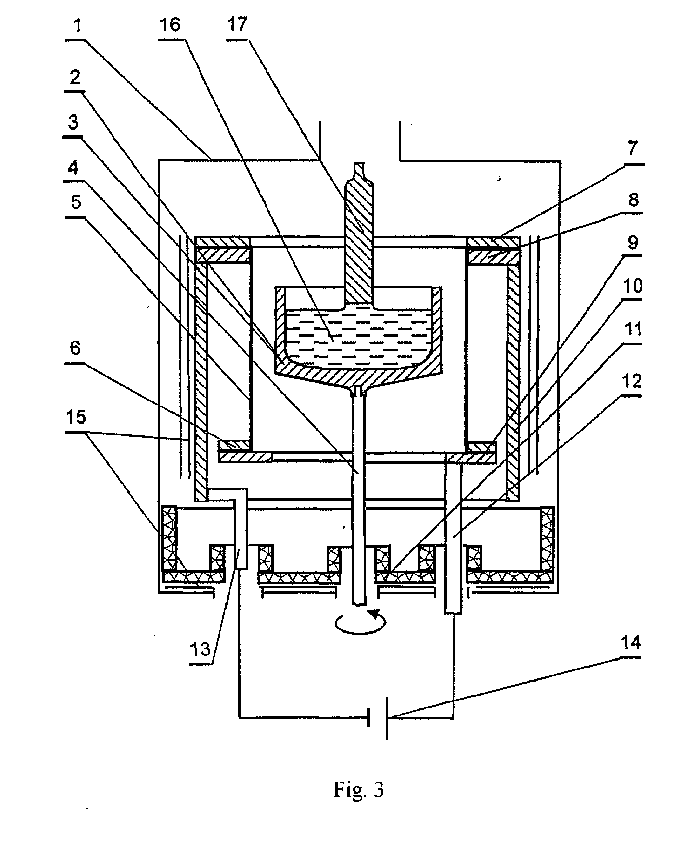

When growing a 150-mm diameter single crystal of silicon from a charge of polycrystalline silicon having mass of 30 kg, a crucible 2 and a support 3 are used which are made integral with one another of silicon nitride and have an outer diameter of 370 mm. The device comprises a side screen/current lead 10 (Figure 3), whereto a graphite ring 8 is attached at the top and a current lead 13 is connected at the bottom. The current lead 12 is connected to the lower pair of graphite rings 6 and 9. The bottom screen 11 is not connected to the electric circuit and it is arranged on the bottom of the chamber 1. The cylindrical heater 5 is made of thermoexpanded rolled graphite. The heater wall thickness is equal to 2 mm (0.002 m). The end faces of the cylinder are cut into petals, which are then bent away and clamped between the rings 7, 8 and 6, 9, respectively. A thin layer of silicon nitride is applied to the inner and outer surfaces of the heater. The screen 10 and the rod 4 are made of graphite and coated with silicon nitride. The screens 10 and 11 have a heat insulation of fabric made of silica fibers. The screen 11 is made of silicon nitride and comprises a bowl, which serves both for heat insulation and for preventing direct interaction of the silicon melt with the water jacket of the chamber 1 in case of an emergency spillage of the melt 16 from the crucible-support 2-3 upon its destruction.

The specific heat of the material of the heater is 2077 J/kg·K (at working temperature of $\approx$ 1600 °C, i. e. 1873 K), the density of the material of the heater $\rho_{st}$= 2000 kg/m$^3$ that is, the product of $\delta \cdot \rho \cdot c$ is equal 8308

J/m$^2$·K. After the crucible 2 is filled with a silicon charge (no doping boron composition is added in this example), the chamber 1 is sealed, vacuum of $10^{-3}$ mm Hg is provided therein, and electric power supply is switched on. Electric current from the power supply 14 passes through the current lead 12 to the rings 6, 9 and to the heater 5, whereupon it flows through the rings 7, 8 and the screen/current lead 10 and via the current lead 13 back to the power supply 14. The heater 5 gets heated up to reach its working temperature of $\approx$ 1600 °C. Due to the heat transfer by radiation from the heater, the silicon charge 16 gets heated up and melts. After this, a seed is lowered down into the melt and a single crystal 17 is grown.

After the process of growing is over, the single crystal is cooled down, removed from the chamber, whereupon samples are cut out of it and both carbon and oxygen contents are determined in the crystal thus produced. Here, the carbon content is 5 x $10^{15}$ cm$^{-3}$, and the oxygen content is 8 x $10^{15}$ cm$^{-3}$. Such oxygen content allows using these single crystals for further neutron doping.

The heater has low sluggishness. The time $\tau$ is 50 s as compared against 450 s for the prototype.

Electric power consumption per 1 kg of finished products decreases here by 10 % and is 140 kW-hour/kg as compared against 155 kW-hour/kg for the prototype.

The heater remains serviceable for as long as 150 cycles of pulling.

Example 4

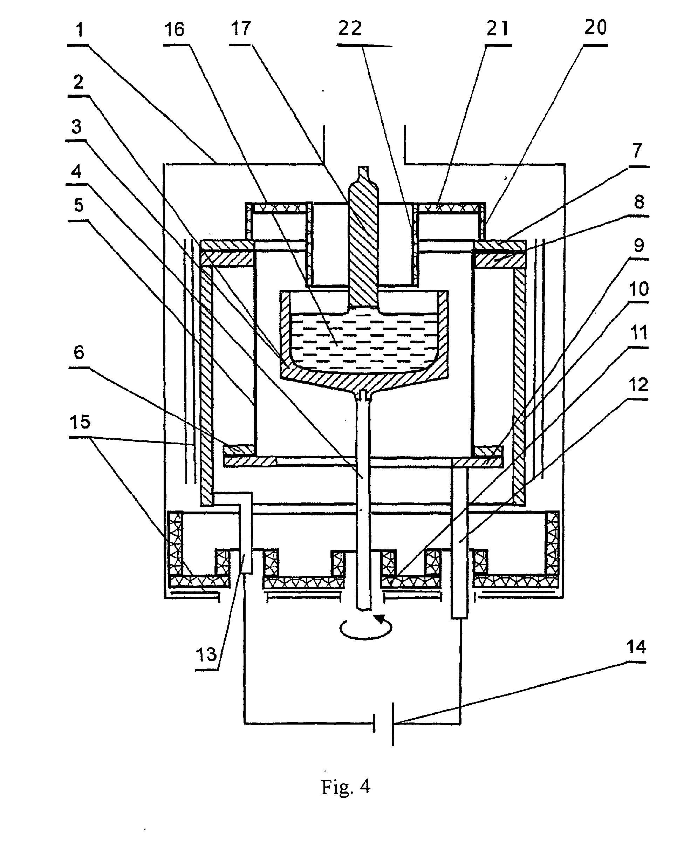

A single crystal is pulled in the device presented in Figure 4. An additional system of upper screens 20, 21, 22 is made of silicon nitride.

The crystal is grown in the same manner as described in Example 3.

After the process of growing is over, the single crystal is cooled down, removed from the chamber, whereupon samples are cut out of it and both carbon and oxygen contents are determined in the crystal thus produced. The carbon content is 5 x $10^{15}$ cm$^{-3}$, and the oxygen content is 8 x $10^{15}$ cm$^{-3}$.

The heater has low sluggishness. The time $\tau$ is 50 s as compared against 450 s for the prototype.

Electric power consumption per 1 kg of finished products decreases here by 20 % and is 125 kW-hour/kg as compared against 155 kW-hour/kg for the prototype.

The heater remains serviceable for as long as 150 cycles of pulling.

Example 5

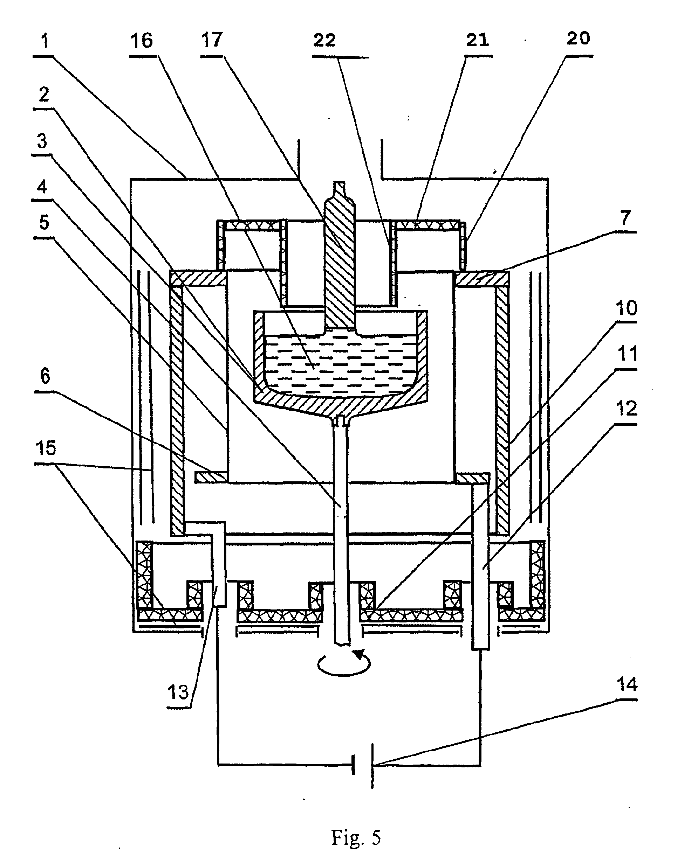

A single crystal is pulled in the device presented in Figure 5, which is an alternative embodiment of the device shown in Figure 4. In distinction thereto, here the rigid rings 6 and 7 of carbon material, by which the ends of the heater are fastened, constitute an integral part with the heater. This part is made as follows: the cylindrical body of the heater is wrapped around a cylindrical steel mandrel. The wrapping is carried out in a machine tool, using simultaneously 10 to 150 carbon fibers mutually intertwined with each other in several directions at the same time as they are impregnated with epoxy resin. Bosses 10 mm high and 20 mm thick are provided on both ends of the heater body. After carrying out the curing operation (annealing at 200°C for as long as 6 hours), these bosses at the ends are machined in a lathe so that they would have the desired dimensions. The cylindrical screen/current lead 10 is made similarly of carbon fibers by way if wrapping thereof and impregnating with a mixture of epoxy resin with graphite crumbs, followed by high-temperature (200°C) annealing. The thickness of this screen/current lead is 15 mm. After the mandrel is removed, a thin layer of carbon nitride is applied to the inner and outer surfaces of the cylinder of the heater 5. The upper end with the ring 7 is connected to the screen/current lead 10, and the lower end with the ring 6 is connected to the current lead 12. Then, all the parts of the heat assembly are coated with silicon nitride, as described herein above.

The specific heat of the material of the heater is 2077 J/kg·K (at working temperature of 1600 °C, i.e. 1873 K), the density of the material of the heater $\rho_{st}$ = 401.22 kg/m$^3$, and the wall thickness of the heater is equal to 0.6 mm (0.0006 m); that is, the product of $\delta \cdot \rho \cdot c$ is equal to 500 J/m$^2$·K.

The crystal is grown in the same manner as described in Example 3.

After the process of growing is over, the single crystal is cooled down, removed from the chamber, whereupon samples are cut out of it and both carbon and oxygen contents are determined in the crystal thus produced. The carbon content is 5 x 10$^{15}$ cm$^{-3}$, and the oxygen content is 8 x 10$^{15}$ cm$^{-3}$.

The heater has low sluggishness. The time $\tau$ is 45 s as compared against 450 s for the prototype.

Electric power consumption per 1 kg of finished products decreases here by 20 % and is 125 kW-hour/kg as compared against 155 kW-hour/kg for the prototype.

The heater remains serviceable for as long as 150 cycles of pulling.

The Best Embodiment of the Invention

Feasibility of the invention characterized by the combination of features presented in the claims can be substantiated by the description of the following example illustrating the best of the embodiments supposed by the Applicant for the claimed invention.

The device is used in growing a single crystal of silicon having a diameter of 150 mm from a 30-kg charge of polycrystalline silicon. In a chamber 1 of the plant, there are arranged a crucible 2 and a support 3 which are made integral with one another of silicon nitride and have an outer diameter of 370 mm (Figure 5). The crucible-support 2-3 is arranged on a rod 4, which is also made of silicon nitride. The crucible-support 2-3 is surrounded by a heater in the form of a cylinder 5, wherein rigid rings 6 and 7, by which the ends of the heater are fastened, constitute an integral part with the heater. This part is made as follows. Carbon fabric of Ural-22 type impregnated with a liquid carbon binder (for instance, epoxy resin, phenol-formaldehyde lacquer, starch glue) is wrapped in two layers around a cylindrical steel mandrel. The wrapping is carried out in a machine tool, with the fabric tensioned and the mandrel prepressed. Bosses are provided on both ends of the heater body by wrapping additionally two strips of fabric. After carrying out the curing operation (annealing at 200 °C for as long as 26 hours), these bosses at the ends are machined in a lathe so that they would have the desired dimensions. After the mandrel is removed, a thin layer of silicon carbide is applied to the inner and outer surfaces of the cylinder of the heater 5. This operation is carried out as follows. A layer of an emulsion containing silicon powder and ethyl alcohol is applied to inner and outer surfaces of the heater (for instance, by means of a brush or a paint sprayer). Thereupon, it is dried in a fume hood at room temperature. Later on, annealing is carried out in a nitrogen atmosphere at temperature of 1100 to 1400 °C for as long as 5 hours at pressure of 0.5 to 1.2 atm., and then at temperature of 1600 °C and at the same pressure.

The upper end with the ring 7 is connected to a side screen/current lead 10, and the lower end with the ring 6, to a current lead 12. The cylindrical screen/current lead 10 is made similarly of carbon fabric by wrapping it and impregnating, followed by a curing operation. Then, all the parts of the heat assembly are coated with a layer of silicon carbide.

The specific heat of the material of the heater is 2077 J/kg·K (at working temperature of 1600 °C, i.e. 1873 K), the density of the starting material of the heater $\rho_{st}$ = 400.00 kg/m$^3$, and the wall thickness of the heater is equal to 1.5 mm (0.00015 m); that is, the product of $\delta \cdot \rho \cdot c$ is equal to 2492 J/m$^2$·K.

A bottom screen 11, which is not connected to the electric circuit, is disposed on the bottom of the chamber 1. The screen 11 is made of a carbon-silicon-carbide composite material and comprises a bowl, which serves both for heat insulation and for preventing direct interaction of the silicon melt with the water jacket of the chamber 1 in case of an emergency spillage of the melt 16 from the crucible-support 2-3 upon a destruction of this part. The screens 10 and 11 have heat insulation 15 of fabric made of silica fibers.

A system of upper screens is mounted in the upper part of the device, the system consisting of a cylindrical screen 20 and a plane horizontal screen 21. This screening allows to reduce heat losses. Besides, a cylindrical screen 22 is mounted which further screens the growing single crystal from the heater, thus allowing to obtain therein a large temperature gradient and increase the rate of growing. The system of additional upper screens is made of silicon nitride.

After the crucible-support 2-3 is filled with a silicon charge, the chamber I is sealed, vacuum of $10^{-3}$ mm Hg is provided therein, and electric power supply is switched on. Electric current from the power supply 14 passes through the current lead 12 to the ring 6 and to the heater 5, whereupon it flows through the ring 7 and the screen/current lead 10 and via the current lead 13 back to the power supply 14. The heater 5 gets heated up to reach its working temperature of ≈ 1600 °C. Due to the heat transfer by radiation from the heater, the silicon charge 16 gets heated up and melts. After this, a seed is lowered down into the melt and a single crystal 17 is grown.

After the process of growing is over, the single crystal is cooled down, removed from the chamber, whereupon samples are cut out of it and both carbon and oxygen contents are determined in the crystal thus produced. Here, the carbon content is 5 x $10^{15}$ cm$^{-3}$, and the oxygen content is 8 x $10^{15}$ cm$^{-3}$. Such oxygen content allows using these single crystals for further neutron doping.

The heater has low sluggishness. The time $\tau$ is 45 s as compared against 450 s for the prototype.

Electric power consumption per 1 kg of finished products decreases here by 20 % and is 125 kW-hour/kg as compared against 155 kW-hour/kg for the prototype.

The heater remains serviceable for as long as 150 cycles of pulling.

(vi) Industrial Applicability

From the examples given herein above to illustrate various embodiments of the invention, it is obvious how the *device for pulling single crystals* can be made and used.

**Claims**

1. A device for pulling single crystals, comprising a crucible with a support, a heater and at least one heat-insulating screen, **characterized in that** the heater is made of a starting flexible carbon-bearing material in the form of a cylinder whose ends are fixed between coaxially arranged rigid rings of carbon material that are connected to a power supply, wherein the heater is made so that the wall thereof has its thickness determined from the relationship:

$$\delta \cdot \rho \cdot c = 500 \text{ to } 8500 \text{ J/m}^2.\text{K,}$$

where:

$\delta$ - heater wall thickness, m;
$\rho$ - density of the material the heater is made of, kg/m$^3$; and
$c$ - specific heat of the material the heater is made of (at working temperature), J/kg.K.

2. The device according to claim 1, **characterized in that** the rings of carbon material are connected to the power supply through heat-insulating screens.

3. The device according to claim 1 or claim 2, **characterized in that** a layer of silicon nitride is provided on the heater surface on the inner and/or outer side thereof

4. The device according to any one of claims 1-3, **characterized in that** the crucible or the support is made of silicon nitride.

5. The device according to any one of claims 1-3, **characterized in that** the crucible and the support are made of silicon nitride so as to be integral with one another.

6. The device according to any one of claims 1-5, **characterized in that** the carbon-bearing material of the heater is further sealed with pyrolytic carbon and/or silicon carbide.

7. The device according to any one of claims 1-6, **characterized in that** it further comprises a heat-insulator of fabric and/or felt made of silica or quartz fibers.

Fig. 1

Fig. 2

Fig. 3

EP 1 498 515 A1

Fig. 4

12

Fig. 5

**INTERNATIONAL SEARCH REPORT**

| International application No. |
|---|
| PCT/RU 03/00116 |

| A. | CLASSIFICATION OF SUBJECT MATTER |
|---|---|

C30B 15/14

According to International Patent Classification (IPC) or to both national classification and IPC

| B. | FIELDS SEARCHED |
|---|---|

Minimum documentation searched (classification system followed by classification symbols)

C30B 15/00, 15/14, H05B 3/34, 3/74, C04B 41/85

Documentation searched other than minimum documentation to the extent that such documents are included in the fields searched

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 10-291896 A (TOYO TANSO KK) 04.11.1998, the abstract | 1-7 |
| A | RU 2119729 C1 (ERMILOV ARTUR NIKOLAEVICH) 27.09.1998, the abstract | 1-7 |
| A | JP 61-044794 A (HITACHI LTD) 04.03.1986, the abstract | 1-7 |
| A | SU 887630 A (GOSUDARSTVENNY NAUCHNO-ISSLEDOVATELSKY I PROEKTNY INSTITUT REDKOMETALLICHESKOI PROMYSHLENNOSTI et al) 07.12.1981 | 1-7 |
| A | RU 2049761 C1 (NAUMENKO V. A. et al) 10.12.1995, the abstract | 1-7 |

☐ Further documents are listed in the continuation of Box C.       ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | | |
| "O" | document referring to an oral disclosure, use, exhibition or other means | "Y" | document of particular relevance; the claimed invention cannot be considered to involve an inventive step when the document is combined with one or more other such documents, such combination being obvious to a person skilled in the art |
| "P" | document published prior to the international filing date but later than the priority date claimed | "&" | document member of the same patent family |

| Date of the actual completion of the international search | Date of mailing of the international search report |
|---|---|
| (22.05.2003) | (19.06.2003) |

| Name and mailing address of the ISA/ RU | Authorized officer |
|---|---|
| | |
| Facsimile No. | Telephone No. |

Form PCT/ISA/210 (second sheet) (July 1992)